# EUROPEAN PATENT SPECIFICATION

(11) **EP 3 620 805 B1**
(45) Date of publication and mention of the grant of the patent: **10.08.2022**
(21) Application number: 18193009.0
(22) Date of filing: 06.09.2018
(51) Int. Cl.: G01R 33/00

(54) **MAGNETIC SENSOR SYSTEM**
MAGNETISCHES SENSORSYSTEM
SYSTÈME DE CAPTEUR MAGNÉTIQUE

(43) Date of publication of application: 11.03.2020
(73) Proprietor: Melexis Technologies SA, 2022 Bevaix (CH)
(72) Inventor: CODDENS, Kristof, 3078 Everberg (BE); LUGANI, Lorenzo, 1110 Morges (CH)
(74) Representative: DenK iP bv

(56) References cited:
- US-A1- 2013 200 909
- US-A1- 2015 070 008
- US-A1- 2015 219 472
- US-A1- 2016 252 599

## Description

### Technical field of the invention

The present invention relates to magnetic sensors and in particular to magnetic sensors having multiple sensing units.

### Background of the invention

Magnetic sensors are used in a variety of position sensing applications. For some of those applications, such as steering or braking in cars, strict safety requirements exist which call for the incorporation of redundancy in the sensing that is performed.

Several approaches have been attempted to incorporate such redundancy. A first approach consists in combining in the same package two magnetic sensor dies side by side. This approach provides electrically independent readouts, but its major drawbacks are that the two magnetic sensing units use are typically based on the same technology and, as the two dies are placed side by side, the two magnetic sensing units do not share the same sensing centre. Instead, these solutions rely on the symmetry of the magnetic field to be sensed, making them very sensitive to off-axis misalignment errors.

A second approach consists in vertically stacking two magnetic sensors. This can for example be achieved by mounting the two sensors on both sides of a printed circuit board, or by integrating them in the same package in the form of stacked dies. However, the vertical stacking introduces a significant vertical gap between the two sensors. Therefore, despite sharing the same planar centre, the two sensor dies may experience significantly different magnetic fields and are thus for instance more prone to airgap variations.

A third approach consists in integrating two magnetic sensors in the same die. This way, the two magnetic sensors can be made to share the same magnetic centre and thus sense the same field. However, a major drawback remains in that the two sensors used are typically identical in type. As such, if a sensing error occurs which is related to the particular sensing technology that is used, both sensors will be affected.

US9625278B2 for example discloses a rotation angle measurement apparatus using a magnetic flux concentrator, in which a first rotation angle θ of a rotating magnet is based upon the strengths of the output signals from a first and a second Hall element pair, and a second rotation angle θc of the rotating magnet is based upon the strengths of the output signals from a third and a fourth Hall element pair. The magnetic flux concentrator therein is shared is common between each these Hall elements, such that the independence of the different sensors is compromised. Consequently, a perturbance in one Hall element could easily spread through the magnetic flux concentrator and affect one or more other Hall elements.

US9470552B2 discloses magnetic field angle sensors that utilize axial and perpendicular sensors collectively to infer a rotational angle. To this end, a sensor system comprises a first sensor and a second sensor, both arranged on a support structure with respect to an axis of rotation of a magnetic field source in such a way that only one of them sense magnetic field components along a direction perpendicular to the axis of rotation. The axial and perpendicular sensor data both representative of the rotational position can be used to improve output angle accuracy by, e.g., calibrating the sensor system. For example, the perpendicular sensor is typically less prone to differences due to assembly tolerances, but is less robust against disturbance magnetic fields than the axial sensor; as such, the perpendicular sensor may be used to calibrate the axial sensor, whereas for operation in the field it is the axial sensor which is relied upon (e.g. solely). However, no reliable redundant measurement is obtained by these sensors. Indeed, while using both sensors to determine errors due to assembly tolerances could give fairly good results, the degree in which errors occurring in the field can be picked up is limited. First, as mentioned above, the perpendicular sensor is less robust in the field, so that its ability to reveal errors by the axial sensor is already compromised. Second, since both sensors measure perpendicular magnetic field components, a change occurring in only one these magnetic field components can be picked up by only one of both sensors.

US20160252599A1 discloses devices and methods where switches associated with a magnetic field sensor are used to provide error information. In some embodiments,-alongside a first analog-to-digital converter coupled to setup comprising a first Hall sensor-a second analog-to-digital converter may additionally or alternatively be used to perform a redundant magnetic field measurement in addition to the result of the first converter using a second Hall sensor (e.g. to provide a measurement with a certain distance to the first Hall sensor, e.g. to measure a magnetic background field). Furthermore, in a variation on these embodiments, a redundant magnetic field measurement may be performed using a different measurement principle (e.g. using a magneto-resistive sensor, such as GMR, TMR or xMR in general) instead of an additional second Hall probe. Such a magnetoresistive sensor may again be connected via multiplexing switches to an analog-to-digital converter. This may further be used in embodiments to improve the independence of the redundant measurement setup (e.g. diversity of measurements: H-fields versus B-fields).

There is thus still a need in the art for magnetic sensor systems which redundantly measure a magnetic field.

### Summary of the invention

It is an object of the present invention to provide good a magnetic sensor system for redundantly measuring a physical quantity associated with a magnetic field. It is a further object of the present invention to provide good methods for fabricating such a magnetic sensor system and good uses associated with such a magnetic sensor system. This objective is accomplished by devices, methods and uses according to the present invention.

In a first aspect, the present invention relates to a magnetic sensor system for redundantly measuring a physical quantity associated with a magnetic field. The magnetic sensor system comprises
i. a substrate,
ii. a first sensor on the substrate, the first sensor being based on a first sensing technology and sensing a parameter characteristic of the magnetic field at a first sensing point in space, and
iii. a second sensor on the substrate, the second sensor being based on a second sensing technology and sensing a parameter characteristic of the magnetic field at a second sensing point in space, the second sensing technology differing from the first sensing technology;
wherein the first sensing point and the second sensing point are substantially aligned in a direction normal to the substrate, wherein a distance along the normal direction between the first sensing point and the second sensing point is less than about 200 µm, such as less than about 100 µm, for instance less than 50 µm or less than 30 µm, preferably less than 10 µm, e.g. less than 5 µm, for instance less than 4 µm, or less than 3 µm, such as less than 1 µm, e.g. less than 500 nm, or less than 300 nm, or less than 100 nm, and wherein the first sensor and the second sensor are both sensitive to a same magnetic field component.

Each of the first and/or the second sensors can comprise a plurality of sub-sensors. For instance, the present invention not being limited thereto, any of the first or second sensors can comprise at least four horizontal Hall plates, or at least two vertical Hall plates.

It is an advantage of embodiments of the present invention that the physical quantity associated with a magnetic field can be measured redundantly and that anomalies (e.g. faults) can be detected by comparing both measured values. It is an advantage of embodiments of the present invention that both measurements can measure the magnetic field in substantially the same spot in space and time. It is an advantage of embodiments of the present invention that the same magnetic field components can be measured and compared. For instance, for making angular measurements, both the first sensor and the second sensor can measure either the Bx and By magnetic field components, or the Bz magnetic field component.

In embodiments of the present invention, the parameter characteristic of the magnetic field at the first sensing point in space and the parameter characteristic of the magnetic field at the second sensing point in space may correspond to a same physical quantity.

It is an advantage of embodiments of the present invention that the comparison may be relatively straightforward by comparing values corresponding to the same physical quantity.

In embodiments of the present invention, the first sensor and the second sensor may be monolithically integrated onto the substrate.

It is an advantage of embodiments of the present invention that the first sensor and the second sensor can be well integrated within a small physical space.

In embodiments of the present invention, a measurement by the first sensor and a measurement by the second sensor may be independent of one another.

It is an advantage of embodiments of the present invention that an influence of the first sensor on the second sensor and vice versa may be limited. It is an advantage of embodiments of the present invention that cross-talk between the first and the second sensor is avoided.

In embodiments, the first sensor and the second sensor may be electrically independent of one another.

It is an advantage of embodiments of the present invention that a signal of the first sensor can be collected and processed separately from a signal of the second sensor, and vice versa.

In embodiments of the present invention, the first sensor may be present on a first portion of the substrate and the second sensor may be present on a second portion of the substrate. In embodiments of the present invention, the first portion and the second portion of the substrate may be electrically independent of one another.

It is an advantage of embodiments of the present invention that the electrical independence of the first and second sensor can be further improved.

In embodiments of the present invention, the magnetic sensor system may comprise a first output node and a second output node. In embodiments of the present invention, the first sensor may be coupled to the first output node and the second sensor may be coupled to the second output node.

It is an advantage of embodiments of the present invention that a comparison between the measurement by the first sensor and the measurement by the second sensor may be performed off-chip.

In embodiments of the present invention, the first sensor may be directly coupled to the first output node and/or the second sensor may be directly coupled to the second output node.

It is an advantage of embodiments of the present invention that a signal from the first and/or from the second sensor can be output directly, without intermediate processing.

In embodiments of the present invention, the magnetic sensor system may comprise a first signal processing unit coupled in-between the first sensor and the first output node and/or the magnetic sensor system may comprise a second signal processing unit coupled in-between the second sensor and the second output node.

It is an advantage of embodiments of the present invention that a signal from the first and/or from the second sensor can be partially or fully processed on-chip.

In embodiments of the present invention, the first signal processing unit and the second signal processing unit may comprise one or more processing elements shared in common.

It is an advantage of embodiments of the present invention that at least some processing elements can be shared for both processing signals and that dedicated processing elements for each signal are not required. It is an advantage of embodiments of the present invention that the independence of the first and second signal can be maintained (cf. processing in a time multiplexed manner) even when sharing processing elements.

In embodiments of the present invention, the magnetic sensor system may comprise a common output node and a common signal processing unit, wherein the first sensor and the second sensor are coupled to the common signal processing unit for processing of their sensing signals, and wherein an output port of the common signal processing unit is coupled to the common output node.

It is an advantage of embodiments of the present invention that the first and second signal can be processed and output using a single processing unit and output node (e.g. in a time multiplexed manner). It is an advantage of embodiments of the present invention that the first and second signal can be fully processed and compared on-chip.

In a second aspect, the present invention relates to a method for forming a magnetic sensor system for redundantly measuring a physical quantity associated with a magnetic field. The method comprising:
a. providing a substrate having a first sensor thereon, the first sensor being based on a first sensing technology and sensing a parameter characteristic of the magnetic field at a first sensing point in space, and
b. integrating a second sensor on the substrate, the second sensor being based on a second sensing technology and sensing a parameter characteristic of the magnetic field at a second sensing point in space, the second sensing technology differing from the first sensing technology;
wherein step b is performed such that the first sensing point and the second sensing point are aligned in a direction normal to the substrate, such that a distance along the normal direction between the first sensing point and the second sensing point is less than about 200 µm, such as less than about 100 µm, for instance less than 50 µm or less than 30 µm, preferably less than 10 µm, e.g. less than 5 µm, for instance less than 4 µm, or less than 3 µm, such as less than 1 µm, e.g. less than 500 nm, or less than 300 nm, or less than 100 nm, and wherein the first sensor and the second sensor are both sensitive to a same magnetic field component.

It is an advantage of embodiments of the present that the magnetic sensor systems can be formed in a relatively straightforward and economic way.

In embodiments of the present invention, step b of integrating the second sensor on the substrate may comprise transferring the second sensor thereon from an auxiliary substrate.

It is an advantage of embodiments of the present invention that the second sensor can be at least partially formed on an auxiliary substrate, prior to being transferred. It is an advantage of embodiments of the present invention that in this way processing steps for forming the second sensor are accessible, which could not be performed when forming the second sensor directly on the substrate (e.g. because the first sensor would be damaged in the process).

In a third aspect, the present invention relates to a use of a magnetic sensor system according to any embodiment of the first aspect, comprising comparing a measurement by the first sensor to a measurement by the second sensor.

It is an advantage of embodiments of the present invention that a measurement by the first sensor to a measurement by the second sensor can be compared relatively easily.

In embodiments, the use may further comprise triggering a signal if the comparison of the measurement by the first sensor to the measurement by the second sensor yields a value higher than a predetermined threshold.

It is an advantage of embodiments of the present invention that a signal (e.g. a warning) can be triggered if a measurement by the first sensor and a measurement by the second sensor differ beyond a predetermined region.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention which is defined by the claims.

The reference figures quoted below refer to the attached drawings.

### Brief description of the drawings

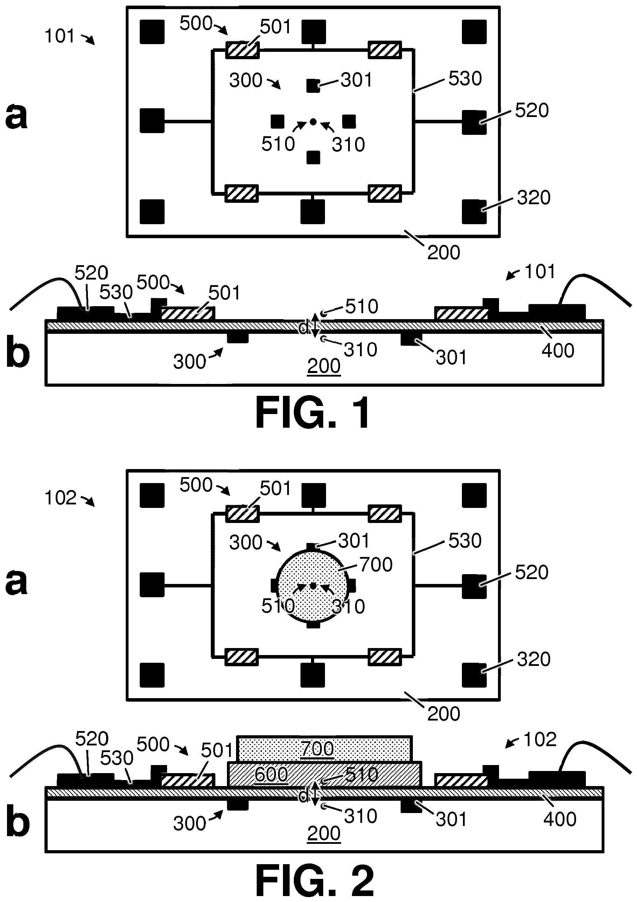

FIGs. 1 to 4 are schematic top (a) and side (b) views of different exemplary magnetic sensor systems in accordance with embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more assemblies. Yet, the invention is only as defined by the claims.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with the subject-matter of each claim standing on its own as a separate embodiment of this invention.

Furthermore, while some embodiments described herein include some but not other features included in other embodiments, combinations of features of different embodiments are meant to be within the scope of the invention, as long as they are comprised in the subject-matter as claimed, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practised without these specific details, as long as these embodiments are comprised in the subject-matter as claimed.

In other instances, well-known methods, structures and techniques have not been shown in detail in order not to obscure an understanding of this description.

In a first aspect, the present invention relates to a magnetic sensor system for redundantly measuring a physical quantity associated with a magnetic field. The magnetic sensor system comprises
i. a substrate,
ii. a first sensor on the substrate, the first sensor being based on a first sensing technology and sensing a parameter characteristic of the magnetic field at a first sensing point in space, and
iii. a second sensor on the substrate, the second sensor being based on a second sensing technology and sensing a parameter characteristic of the magnetic field at a second sensing point in space, the second sensing technology differing from the first sensing technology;
wherein the first sensing point and the second sensing point are substantially aligned in a direction normal to the substrate, wherein a distance along the normal direction between the first sensing point and the second sensing point is less than 200 µm, such as less than about 100 µm, for instance less than 50 µm or less than about 30 µm, preferably less than 10 µm, e.g. less than 5 µm, for instance less than 4 µm, or less than 3 µm, such as less than 1 µm, e.g. less than 500nm, or less than 300 nm, or less than 100 nm, and wherein the first sensor and the second sensor are both sensitive to a same magnetic field component.

In embodiments of the present invention, the physical quantity associated with the magnetic field may be a magnetic field component or a quantity derived therefrom, such as a rotation angle of the magnetic field or a position of a magnetic field source (e.g. a magnet). In embodiments, redundantly measuring a physical quantity associated with a magnetic field may comprise measuring substantially the same physical quantity twice or more. To this end, the first and the second sensor preferably each measure a parameter corresponding to the physical quantity, or a parameter from which said physical quantity can be derived, respectively at a first and second sensing point in space; this first and second sensing point being substantially close to one another. Preferably, both parameters measured by the first and second sensor are reflective of a same magnetic field component, yet more preferably reflective of all the same magnetic field components. Moreover, the first and second sensor preferably also measure their respective parameter substantially simultaneously (i.e. substantially close in the time dimension; e.g. within a second, milli-, micro- or nanosecond from one another). By aligning the characteristics of the magnetic field that is sensed by the first and the second sensor (in space, in time and in magnetic components) as much as possible, while nevertheless performing the measurement based on different sensing technologies, the comparison of the two measurements is made easier and the ability of the magnetic sensor system to detect faults in the measurement is optimized. In contrast, performing two measurements based on the same sensing technology as in the prior art lowers the ability to detect faults, as e.g. the fault may affect both sensors simultaneously. Furthermore, the further the characteristics of the magnetic field that is sensed by the first and the second sensor (in space, in time and in magnetic components) diverge, the more likely that the ability to detect faults is affected and the higher technical constraints in terms of off-axis misalignment or airgap variations become.

In embodiments of the present invention, the substrate may be a semiconductor substrate, such as a Si, Ge, SiₓGe_{y}, semiconductor-on-insulator or III-V substrate.

In embodiments of the present invention, the first sensor and the second sensor may be monolithically integrated onto the substrate.

In embodiments of the present invention, the first sensor and/or the second sensor may comprise one or more elements selected from a vertical Hall plate, a horizontal Hall plate, an anisotropic magnetoresistive element, a giant magnetoresistive element, a tunnel magnetoresistive element or a fluxgate element. In embodiments of the present invention, the one or more elements may be independently based on a Si, Ge, SiₓGe_{y} or III-V material. In preferred embodiments, the first sensor may comprise one or more Hall plates (e.g. independently selected from a vertical Hall plate and horizontal Hall plate) and the second sensor may comprise one or more magnetoresistive elements (e.g. independently selected from an anisotropic magnetoresistive element, a giant magnetoresistive element and a tunnel magnetoresistive element). For example, the first sensor may be a Hall sensor (e.g. a vertical or horizontal Hall sensor) and/or the second sensor may be a magnetoresistive sensor (e.g. an anisotropic magnetoresistive sensor, giant a magnetoresistive sensor or a tunnel magnetoresistive sensor). In embodiments, the first sensor may comprise one or more horizontal Hall plates and an integrated magnetic concentrator and/or vertical hall plates. In embodiments, the Hall sensor may sense a magnetic field direction by measuring one or more magnetic field components along different axes. In embodiments, a magnetoresistive sensor may sense a magnetic field direction by measuring a cosine or sine of the magnetic field direction.

In embodiments, the parameter characteristic of the magnetic field at the first sensing point in space and/or the parameter characteristic of the magnetic field at the second sensing point in space may correspond to the physical quantity associated with the magnetic field, or to a parameter from which said physical quantity can be derived. In preferred embodiments, the parameter characteristic of the magnetic field at the first sensing point in space and the parameter characteristic of the magnetic field at the second sensing point in space may correspond to a same physical quantity (e.g. to the physical quantity associated with the magnetic field, or to a parameter from which said physical quantity can be derived). In embodiments, the first sensor may measure in a same range of values as the second sensor. In embodiments, the second sensor may measure the parameter characteristic of the magnetic field at the second sensing point in space slower, with lower resolution and/or with higher noise than the first sensor measures the parameter characteristic of the magnetic field at the first sensing point in space.

In embodiments, the first sensing point in space may be a sensing centre (e.g. a geometric or magnetic centre of an area or volume in which the first sensor is sensitive to a magnetic field) or a sensing sweet-spot (e.g. a point in space in which the first sensor is most sensitive) of the first sensor. Likewise, in embodiments, the second sensing point in space may be a sensing centre (e.g. a geometric or magnetic centre of an area or volume in which the second sensor is sensitive to a magnetic field) or a sensing sweet-spot (e.g. a point in space in which the second sensor is most sensitive) of the second sensor.

In embodiments, the first sensing point and the second sensing point may substantially align in a direction normal to the substrate if a lateral distance (e.g. a separation distance when both are projected on a same plane parallel to the substrate) between the first sensing centre and the second sensing centre is less than 200 µm, such as less than about 100 µm, for instance less than 50 µm or less than about 30 µm, preferably less than 10 µm, e.g. less than 5 µm, for instance less than 4 µm, or less than 3 µm, such as less than 1 µm, e.g. less than 500 nm, or less than 300 nm, or less than 100 nm,. In preferred embodiments, when projecting both the first sensing point and the second sensing point onto a same plane parallel to the substrate (e.g. onto the substrate surface), the second sensing point may overlap the first sensing point. In embodiments, the second sensor may be arranged such that it surrounds the first sensor.

In embodiments, the first sensor and the second sensor being sensitive to the same magnetic field component may measure within a common plane or along a common direction. In embodiments, the first sensor may measure along a first direction and the second sensor may measure along a second direction, the first direction and the second direction not being perpendicular to one another. In embodiments, the first sensor and/or the second sensor may measure in 1 dimension (1D), 2 dimensions (2D) or 3 dimensions (3D).

In embodiments, the second sensing technology differing from the first sensing technology may comprise a difference in the underlying physical sensing principle (e.g. Hall-effect vs. magnetoresistance, or anisotropic magnetoresistance vs. giant magnetoresistance) or a difference in the transducer geometry (e.g. vertical Hall sensor vs horizontal Hall sensor) or a difference in the implementation (e.g. n-in-p vs. p-in-n).

In embodiments, a measurement by the first sensor and a measurement by the second sensor may be independent of one another. For example, the first and the second sensor may be arranged such that a distortion of the magnetic field by either the first or second sensor is not sensed by the other of the first or second sensor. In this way, cross-talk between both sensors is avoided.

In embodiments, the first sensor and the second sensor may be electrically independent of one another. For example, interconnections to the first sensor may run separately from interconnections to the second sensor; e.g. up to a signal processing unit, which may optionally be (partially) shared. In embodiments, the interconnections to the first sensor may be fabricated in the substrate and the interconnections to the second sensor may comprise a metallic redistribution layer overlaying the substrate. In embodiments, the first sensor may be present on a first portion of the substrate and the second sensor may be present on a second portion of the substrate. In embodiments, the first portion and the second portion of the substrate may be electrically independent of one another. In embodiments, an insulating trench (e.g. a deep trench insulation) may electrically separate the first portion and the second portion of the substrate.

In embodiments, the magnetic sensor system may comprise a first output node and a second output node. In embodiments, the first sensor may be coupled to the first output node and the second sensor may be coupled to the second output node.

In embodiments, the first sensor may be directly coupled to the first output node and/or the second sensor may be directly (e.g. without any intermediate active elements, such as a signal processing unit) coupled to the second output node.

In embodiments, the first sensor may be indirectly coupled to the first output node and/or the second sensor may be indirectly coupled to the second output node. In embodiments, the magnetic sensor system may comprise a first signal processing unit coupled in-between the first sensor and the first output node and/or the magnetic sensor system may comprise a second signal processing unit coupled in-between the second sensor and the second output node.

In embodiments, the first signal processing unit and the second signal processing unit may comprise one or more processing elements shared in common. The first and second signal processing units may for example comprise independent amplification paths, while sharing the same analog-to-digital converter (ADC) and/or digital postprocessing resources.

In embodiments, the magnetic sensor system may comprise a common output node and a common signal processing unit, wherein the first sensor and the second sensor are coupled to the common signal processing unit for processing of their sensing signals (e.g. the parameters characteristic of the magnetic field at a first and second sensing point in space), and wherein an output port of the common signal processing unit is coupled to the common output node

In embodiments, the first sensor and the second sensor can be read and/or processed in parallel, or can be read and/or processed in a time multiplexed manner. Reading both in a time multiplexed manner can enable some (e.g. the ADC) or all components of the signal processing units to be shared in common.

In a second aspect, the present invention relates to a method for forming a magnetic sensor system for redundantly measuring a physical quantity associated with a magnetic field. The method comprising:
a. providing a substrate having a first sensor thereon, the first sensor being based on a first sensing technology and sensing a parameter characteristic of the magnetic field at a first sensing point in space, and
b. integrating a second sensor on the substrate, the second sensor being based on a second sensing technology and sensing a parameter characteristic of the magnetic field at a second sensing point in space, the second sensing technology differing from the first sensing technology;
wherein step b is performed such that the first sensing point and the second sensing point are aligned in a direction normal to the substrate, such that a distance along the normal direction between the first sensing point and the second sensing point is less than 200 µm, such as less than about 100 µm, for instance less than 50 µm or less than about 30 µm, preferably less than 10 µm, e.g. less than 5 µm, for instance less than 4 µm, or less than 3 µm, such as less than 1 µm, e.g. less than 500 nm, or less than 300 nm, or less than 100 nm, and wherein the first sensor and the second sensor are both sensitive to a same magnetic field component.

In embodiments of the present invention, providing the substrate having the first sensor thereon may comprise a step of forming the first sensor in the substrate. Forming the first sensor in the substrate may for example comprise a step of doping a bulk or epitaxial region of the substrate to increase a charge carrier concentration.

In embodiments, step b of integrating the second sensor on the substrate may comprise transferring the second sensor thereon from an auxiliary substrate (e.g. using transfer printing). In alternative embodiments, step b of integrating the second sensor on the substrate may comprise growing or forming the second sensor on the substrate.

In a third aspect, the present invention relates to a use of a magnetic sensor system according to any embodiment of the first aspect, comprising comparing a measurement by the first sensor to a measurement by the second sensor.

In embodiments, the comparison may be made inside the sensor system (e.g. in the same die package) or outside the sensor system (e.g. the die package may output the measurement results of both sensors separately and the comparison may be performed by a further comparator system).

In embodiments, the use may further comprise triggering a signal if the comparison of the measurement by the first sensor to the measurement by the second sensor yields a value higher than a predetermined threshold. In embodiments of the present invention, the signal may be triggered in the sensor system (e.g. in the same die package, and for example provided as an output by said die package) or outside the sensor system (e.g. by a comparator system). In embodiments of the present invention, the predetermined threshold may be an absolute value or a relative value (e.g. corresponding to a difference of 1%, 5% or 10%). In embodiments of the present invention, the predetermined threshold may be a static value (e.g. a pre-programmed value) or a dynamic value (e.g. adjustable during operation).

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example: Magnetic sensor systems

A first exemplary magnetic sensor system 101 is shown in FIG. 1. The system comprises for instance a semiconductor, e.g. Si, Hall first sensor 300 integrated on a semiconductor, e.g. Si, die substrate 200. FIG. 1a depicts 4 horizontal Hall plates 301 of one horizontal Hall first sensor 300, but the first sensor 300 could likewise comprise a vertical Hall plate or a combination of horizontal and vertical Hall plates, or a combination of vertical hall plates and horizontal Hall plates and IMC. A first integrated circuit (not depicted) for reading and processing a signal of the first sensor 300 is formed in the substrate, connects with said first sensor 300 and couples to a first output 320 of the sensor system 101. The first sensor 300 and integrated circuit on the substrate 200 may for instance be obtained using standard CMOS (Complementary Metal Oxide Semiconductor) processing. The first sensor 300 illustrated in FIG. 1 is covered with an electrical insulation layer 400 and a second sensor 500 comprising for instance magnetoresistive elements 501 (4 magnetoresistive elements 501 are depicted in FIG. 1a) is integrated thereon (e.g. by transfer printing). The first sensor 300 and the second sensor 500 are arranged such that their respective sensing centres 310 and 510 substantially overlap in the top view of FIG. 1a (i.e. the first sensing centre 310 and the second sensing centre 510 are substantially aligned in the direction normal to the substrate 200). When again viewed from the top, the second sensor 500 furthermore surrounds the first sensor 300, but the elements 501 of the second sensor 500 are nevertheless spaced sufficiently far from the elements 301 of the first sensor 300. In this way, distortions in the magnetic field generated by either the first sensor 300 or the second sensor 500 do not affect the measurement performed by the second sensor 500 or the first sensor 300, respectively (i.e. the measurements by the first sensor 300 and the second sensor 500 are independent of one another). Moreover, due to the selected construction, the two sensing centres 310 and 510 are also close to one another in the vertical direction (i.e. the distance d along the normal direction between the first sensing point 310 and the second sensing point 510 is small, e.g. less than 10 µm, e.g. about 3 µm). As such, the first sensor 300 and the second sensor 500 perform their respective measurements at substantially the same location in space. The second sensor 500 is furthermore interconnected to a second integrated circuit 530 (for reading and processing a signal of the second sensor 500) coupled to a second output 520 of the sensor system 101. By coupling the first sensor 300 and the second sensor 500 directly to their respective outputs 320 and 520, the two sensors 300 and 500 are electrically independent of one another. Alternatively, the first sensor and the second sensor may be connected to an integrated circuit which is (possibly partially) shared between both, e.g. the first integrated circuit and the second integrated circuit may share an analog-to-digital converter (ADC).

FIG. 2 depicts a second exemplary magnetic sensor system 102. This magnetic sensor system 102 is analogous to the first exemplary magnetic sensor system 102, but an IMC 700 (integrated magnetic concentrator) is additionally incorporated on a spacer 600 above the Hall first sensor 300. The IMC 700 enables the horizontal Hall plates 301 to be sensitive to in-plane magnetic fields (i.e. parallel to the substrate 200) and allow to make a 2D or 3D Hall first sensor 300. The IMC 700 may in this exemplary system 102 be provided before or after integration of the second sensor 500.

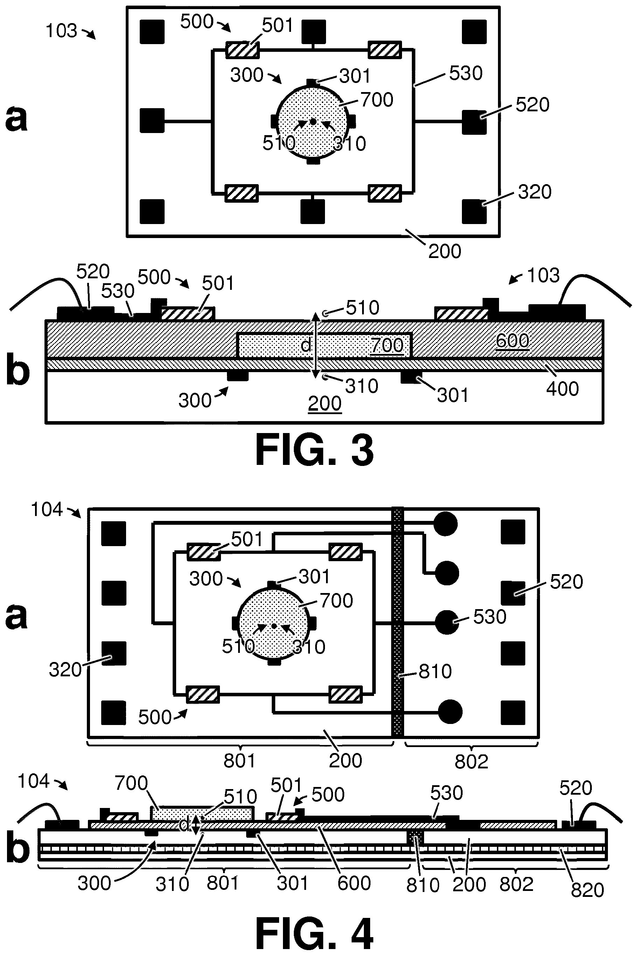

An alternative way to incorporate the IMC 700 is depicted as a third exemplary magnetic sensor system 103 in FIG. 3, where the IMC 700 is provided before integration of the second sensor 500, directly on the electrical insulation layer 400. In turn, the spacer 600 is provided over the IMC 700. The second sensor 500 is then formed on the spacer 600 rather than on the electrical insulation layer 400. Due to the relatively high thickness of the IMC (about 30 µm), in this example the vertical separation between the first and second sensing centers is higher than in other embodiments.

In another exemplary magnetic sensor system 104, shown in FIG. 4, the Si die substrate 200 is split into two electrically isolated portions 801 and 802, e.g. isolated from one another by means of a deep trench insulation 810 and a buried oxide layer 820 (as are known in silicon-on-insulator technology). The first portion comprises both sensors (cf. the first exemplary sensor system 104) as well as the first integrated circuit (not depicted) connected to the first sensor 300 and the corresponding first output 320. The second sensor 500 is connected to the second integrated circuit and the corresponding second output 520, which are located on the second portion. As both integrated circuits and outputs are located on two electrically isolated portions, the electrical independence of the read-out of the first sensor 300 and the second sensor 500 is further improved. The exemplary sensor system 104 in FIG. 4 further depicts an IMC 700 as in the second exemplary sensor system 104, but this IMC 700 can in embodiments be omitted (e.g. as is described for the first exemplary sensor system 104) or be incorporated in a different way (e.g. as is described for the third exemplary sensor system 104).

It is to be understood that although preferred embodiments, specific constructions and configurations, as well as materials, have been discussed herein for devices according to the present invention, various changes or modifications in form and detail may be made without departing from the scope and technical teachings of this invention as claimed.

For example, any formulas given above are merely representative of procedures that may be used. Functionality may be added or deleted from the block diagrams and operations may be interchanged among functional blocks. Steps may be added or deleted to methods described within the scope of the present invention, which is defined only by the scope of the appended claims.

## Claims

1. A magnetic sensor system (101) for redundantly measuring a physical quantity associated with a magnetic field, comprising
i. a substrate (200),
ii. a first sensor (300) on the substrate (200), the first sensor (300) being based on a first sensing technology and sensing a parameter characteristic of the magnetic field at a first sensing point (310) in space, and
iii. a second sensor (500) on the substrate (200), the second sensor (500) being based on a second sensing technology and sensing a parameter characteristic of the magnetic field at a second sensing point (510) in space, the second sensing technology differing from the first sensing technology;
wherein the first sensor (300) and the second sensor (500) are both sensitive to a same magnetic field component, and
**characterized in that**
- the first sensing point (310) and the second sensing point (510) are substantially aligned in a direction normal to the substrate (200), and
- a distance along the normal direction between the first sensing point (310) and the second sensing point (510) is less than 200 µm.

2. The magnetic sensor according to claim 1, wherein the parameter characteristic of the magnetic field at the first sensing point (310) in space and the parameter characteristic of the magnetic field at the second sensing point (510) in space correspond to a same physical quantity.

3. The magnetic sensor according to any of the previous claims, wherein the first sensor (300) and the second sensor (500) are monolithically integrated into the substrate (200).

4. The magnetic sensor according to any of the previous claims, wherein a measurement by the first sensor (300) and a measurement by the second sensor (500) are independent of one another.

5. The magnetic sensor according to any of the previous claims, wherein the first sensor (300) and the second sensor (500) are electrically independent of one another.

6. The magnetic sensor according to claim 5, wherein the first sensor (300) is present on a first portion of the substrate (200) and wherein the second sensor (500) is present on a second portion of the substrate (200), and wherein the first portion and the second portion of the substrate (200) are electrically independent from one another.

7. The magnetic sensor according to claims 5 or 6, comprising a first output (320) node and a second output (520) node, wherein the first sensor (300) is coupled to the first output (320) node and the second sensor (500) is coupled to the second output (520) node.

8. The magnetic sensor according to claim 7, wherein the first sensor (300) is directly coupled to the first output (320) node and/or the second sensor (500) is directly coupled to the second output (520) node.

9. The magnetic sensor according to claim 7, comprising a first signal processing unit coupled in-between the first sensor (300) and the first output (320) node and/or comprising a second signal processing unit coupled in-between the second sensor (500) and the second output (520) node.

10. The magnetic sensor according to claim 9, wherein the first signal processing unit and the second signal processing unit comprise one or more processing elements shared in common.

11. The magnetic sensor according to claims 5 or 6, comprising a common output node and a common signal processing unit, wherein the first sensor (300) and the second sensor (500) are coupled to the common signal processing unit for processing of their sensing signals, and wherein an output port of the signal processing unit is coupled to the common output node.

12. A method for forming a magnetic sensor system (101) for redundantly measuring a physical quantity associated with a magnetic field, comprising
a. providing a substrate (200) having a first sensor (300) thereon, the first sensor (300) being based on a first sensing technology and sensing a parameter characteristic of the magnetic field at a first sensing point (310) in space, and
b. integrating a second sensor (500) on the substrate (200), the second sensor (500) being based on a second sensing technology and sensing a parameter characteristic of the magnetic field at a second sensing point (510) in space, the second sensing technology differing from the first sensing technology;
wherein the first sensor (300) and the second sensor (500) are both sensitive to a same magnetic field component, and
**characterized in that** step b is performed such that
- the first sensing point (310) and the second sensing point (510) are aligned in a direction normal to the substrate (200), and
- a distance along the normal direction between the first sensing point (310) and the second sensing point (510) is less than 200 µm.

13. The method according to claim 12, wherein step b of integrating the second sensor (500) on the substrate (200) comprises transferring the second sensor (500) thereon from an auxiliary substrate (200).

14. Use of a magnetic sensor system (101) according to any of claims 1 to 11, comprising comparing a measurement by the first sensor (300) to a measurement by the second sensor (500).

15. The use according to claim 14, further comprising triggering a signal if the comparison of the measurement by the first sensor (300) to the measurement by the second sensor (500) yields a value higher than a predetermined threshold.

## Patentansprüche

1. Magnetsensorsystem (101) zum redundanten Messen einer physikalischen Größe, die einem Magnetfeld zugehörig ist, umfassend:
i.- ein Substrat (200),
ii.- einen ersten Sensor (300) auf dem Substrat (200), wobei der erste Sensor (300) auf einer ersten Erfassungstechnologie basiert und eine Parametereigenschaft des Magnetfelds bei einem ersten Erfassungspunkt (310) im Raum erfasst, und
iii.- einen zweiten Sensor (500) auf dem Substrat (200), wobei der zweite Sensor (500) auf einer zweiten Erfassungstechnologie basiert und eine Parametereigenschaft des Magnetfelds bei einem zweiten Erfassungspunkt (510) im Raum erfasst, wobei sich die zweite Erfassungstechnologie von der ersten Erfassungstechnologie unterscheidet;
- wobei sowohl der erste Sensor (300) als auch der zweite Sensor (500) gegen eine selbe Magnetfeldkomponente empfindlich sind, und
- **dadurch gekennzeichnet, dass**
- der erste Erfassungspunkt (310) und der zweite Erfassungspunkt (510) im Wesentlichen in einer Richtung normal zu dem Substrat (200) ausgerichtet sind und
- ein Abstand entlang der normalen Richtung zwischen dem ersten Erfassungspunkt (310) und dem zweiten Erfassungspunkt (510) geringer als 200 µm ist.

2. Magnetsensor nach Anspruch 1, wobei die Parametereigenschaft des Magnetfelds bei dem ersten Erfassungspunkt (310) im Raum und die Parametereigenschaft des Magnetfelds bei dem zweiten Erfassungspunkt (510) im Raum einer selben physikalischen Größe entsprechen.

3. Magnetsensor nach einem der vorstehenden Ansprüche, wobei der erste Sensor (300) und der zweite Sensor (500) monolithisch in dem Substrat (200) integriert sind.

4. Magnetsensor nach einem der vorstehenden Ansprüche, wobei eine Messung durch den ersten Sensor (300) und eine Messung durch den zweiten Sensor (500) unabhängig voneinander sind.

5. Magnetsensor nach einem der vorstehenden Ansprüche, wobei der erste Sensor (300) und der zweite Sensor (500) elektrisch unabhängig voneinander sind.

6. Magnetsensor nach Anspruch 5, wobei der erste Sensor (300) auf einem ersten Abschnitt des Substrats (200) vorhanden ist und wobei der zweite Sensor (500) auf einem zweiten Abschnitt des Substrats (200) vorhanden ist, und wobei der erste Abschnitt und der zweite Abschnitt des Substrats (200) elektrisch unabhängig voneinander sind.

7. Magnetsensor nach Anspruch 5 oder 6, umfassend einen ersten Ausgangs- (320) -knoten und einen zweiten Ausgangs- (520) -knoten, wobei der erste Sensor (300) mit dem ersten Ausgangs- (320) -knoten gekoppelt ist und der zweite Sensor (500) mit dem zweiten Ausgangs- (520) -knoten gekoppelt ist.

8. Magnetsensor nach Anspruch 7, wobei der erste Sensor (300) direkt mit dem ersten Ausgangs- (320) -knoten gekoppelt ist und/oder der zweite Sensor (500) direkt mit dem zweiten Ausgangs- (520) -knoten gekoppelt ist.

9. Magnetsensor nach Anspruch 7, umfassend eine erste Signalverarbeitungseinheit, die zwischen dem ersten Sensor (300) und dem ersten Ausgangs- (320) - knoten gekoppelt ist und/oder umfassend eine zweite Signalverarbeitungseinheit, die zwischen dem zweiten Sensor (500) und dem zweiten Ausgangs- (520) -knoten gekoppelt ist.

10. Magnetsensor nach Anspruch 9, wobei die erste Signalverarbeitungseinheit und die zweite Signalverarbeitungseinheit ein oder mehrere Verarbeitungselemente umfassen, die sie sich miteinander teilen.

11. Magnetsensor nach Anspruch 5 oder 6, umfassend einen gemeinsamen Ausgangsknoten und eine gemeinsame Signalverarbeitungseinheit, wobei der erste Sensor (300) und der zweite Sensor (500) mit der gemeinsamen Signalverarbeitungseinheit gekoppelt sind, um deren Erfassungssignale zu verarbeiten, und wobei ein Ausgangsanschluss der Signalverarbeitungseinheit mit dem gemeinsamen Ausgangsknoten gekoppelt ist.

12. Verfahren zum Bilden eines Magnetsensorsystems (101) zum redundanten Messen einer physikalischen Größe, die einem Magnetfeld zugehörig ist, umfassend
a.- Bereitstellen eines Substrats (200), das einen ersten Sensor (300) darauf aufweist, wobei der erste Sensor (300) auf einer ersten Erfassungstechnologie basiert und eine Parametereigenschaft des Magnetfelds bei einem ersten Erfassungspunkt (310) im Raum erfasst, und
b.- Integrieren eines zweiten Sensors (500) auf dem Substrat (200), wobei der zweite Sensor (500) auf einer zweiten Erfassungstechnologie basiert und eine Parametereigenschaft des Magnetfelds bei einem zweiten Erfassungspunkt (510) im Raum erfasst, wobei sich die zweite Erfassungstechnologie von der ersten Erfassungstechnologie unterscheidet;
- wobei sowohl der erste Sensor (300) als auch der zweite Sensor (500) gegen eine selbe Magnetfeldkomponente empfindlich sind, und
- **dadurch gekennzeichnet, dass** Schritt b so durchgeführt wird, dass
- der erste Erfassungspunkt (310) und der zweite Erfassungspunkt (510) in einer Richtung normal zu dem Substrat (200) ausgerichtet sind und
- ein Abstand entlang der normalen Richtung zwischen dem ersten Erfassungspunkt (310) und dem zweiten Erfassungspunkt (510) geringer als 200 µm ist.

13. Verfahren nach Anspruch 12, wobei Schritt b zum Integrieren des zweiten Sensors (500) auf dem Substrat (200) umfasst, den zweiten Sensor (500) von einem Hilfssubstrat (200) darauf zu übertragen.

14. Verwendung eines Magnetsensorsystems (101) nach einem der Ansprüche 1 bis 11, umfassend Vergleichen einer Messung durch den ersten Sensor (300) mit einer Messung durch den zweiten Sensor (500).

15. Verwendung nach Anspruch 14, weiter umfassend Auslösen eines Signals, falls der Vergleich der Messung durch den ersten Sensor (300) mit der Messung durch den zweiten Sensor (500) zu einem höheren Wert als einer vorgegebenen Schwelle führt.

## Revendications

1. Un système de capteur magnétique (101) pour mesurer de manière redondante une quantité physique associée à un champ magnétique, comprenant
- i. un substrat (200),
- ii. un premier capteur (300) sur le substrat (200), le premier capteur (300) étant basé sur une première technologie de détection et détectant un paramètre caractéristique du champ magnétique à un premier point de détection (310) dans l'espace, et
- iii. un second capteur (500) sur le substrat (200), le second capteur (500) étant basé sur une seconde technologie de détection et détectant un paramètre caractéristique du champ magnétique à un second point de détection (510) dans l'espace, la seconde technologie de détection étant différente de la première technologie de détection ;
dans lequel le premier capteur (300) et le second capteur (500) sont tous les deux sensibles à une même composante de champ magnétique, et
**caractérisé en ce que**
- le premier point de détection (310) et le second point de détection (510) sont sensiblement alignés dans une direction normale au substrat (200), et
- une distance le long de la direction normale entre le premier point de détection (310) et le second point de détection (510) est inférieure à 200 µm.

2. Le capteur magnétique selon la revendication 1, dans lequel le paramètre caractéristique du champ magnétique au premier point de détection (310) dans l'espace et le paramètre caractéristique du champ magnétique au second point de détection (510) dans l'espace correspondent à une même quantité physique.

3. Le capteur magnétique selon l'une quelconque des revendications précédentes, dans lequel le premier capteur (300) et le second capteur (500) sont intégrés de manière monolithique dans le substrat (200).

4. Le capteur magnétique selon l'une quelconque des revendications précédentes, dans lequel une mesure par le premier capteur (300) et une mesure par le second capteur (500) sont indépendantes l'une de l'autre.

5. Le capteur magnétique selon l'une quelconque des revendications précédentes, dans lequel le premier capteur (300) et le second capteur (500) sont électriquement indépendants l'un de l'autre.

6. Le capteur magnétique selon la revendication 5, dans lequel le premier capteur (300) est présent sur une première partie du substrat (200) et dans lequel le second capteur (500) est présent sur une seconde partie du substrat (200), et dans lequel la première partie et la seconde partie du substrat (200) sont électriquement indépendantes l'une de l'autre.

7. Le capteur magnétique selon les revendications 5 ou 6, comprenant un premier nœud de sortie (320) et un second nœud de sortie (520), dans lequel le premier capteur (300) est couplé au premier nœud de sortie (320) et le second capteur (500) est couplé au second nœud de sortie (520).

8. Le capteur magnétique selon la revendication 7, dans lequel le premier capteur (300) est directement couplé au premier nœud de sortie (320) et/ou le second capteur (500) est directement couplé au second nœud de sortie (520).

9. Le capteur magnétique selon la revendication 7, comprenant une première unité de traitement de signal couplée entre le premier capteur (300) et le premier nœud de sortie (320) et/ou comprenant une seconde unité de traitement de signal couplée entre le second capteur (500) et le second nœud de sortie (520).

10. Le capteur magnétique selon la revendication 9, dans lequel la première unité de traitement de signal et la seconde unité de traitement de signal comprennent un ou plusieurs éléments de traitement partagés en commun.

11. Le capteur magnétique selon les revendications 5 ou 6, comprenant un nœud de sortie commun et une unité de traitement de signal commune, dans lequel le premier capteur (300) et le second capteur (500) sont couplés à l'unité de traitement de signal commune pour le traitement de leurs signaux de détection, et dans lequel un port de sortie de l'unité de traitement de signal est couplé au nœud de sortie commun.

12. Un procédé de formation d'un système de capteur magnétique (101) pour mesurer de manière redondante une quantité physique associée à un champ magnétique, comprenant
- a. la fourniture d'un substrat (200) sur lequel se trouve un premier capteur (300), le premier capteur (300) étant basé sur une première technologie de détection et détectant un paramètre caractéristique du champ magnétique à un premier point de détection (310) dans l'espace, et
- b. l'intégration d'un second capteur (500) sur le substrat (200), le second capteur (500) étant basé sur une seconde technologie de détection et détectant un paramètre caractéristique du champ magnétique à un second point de détection (510) dans l'espace, la seconde technologie de détection étant différente de la première technologie de détection ;
dans lequel le premier capteur (300) et le second capteur (500) sont tous les deux sensibles à une même composante de champ magnétique, et
**caractérisé en ce que** l'étape b est effectuée de telle sorte que
- le premier point de détection (310) et le second point de détection (510) soient alignés dans une direction normale au substrat (200), et
- une distance le long de la direction normale entre le premier point de détection (310) et le second point de détection (510) soit inférieure à 200 µm.

13. Le procédé selon la revendication 12, dans lequel l'étape b d'intégration du second capteur (500) sur le substrat (200) comprend le transfert du second capteur (500) sur celui-ci à partir d'un substrat auxiliaire (200).

14. Utilisation d'un système de capteur magnétique (101) selon l'une quelconque des revendications 1 à 11, comprenant la comparaison d'une mesure par le premier capteur (300) à une mesure par le second capteur (500).

15. l'utilisation selon la revendication 14, comprenant en outre le déclenchement d'un signal si la comparaison de la mesure par le premier capteur (300) à la mesure par le second capteur (500) donne une valeur supérieure à un seuil prédéterminé.
